# EUROPEAN PATENT SPECIFICATION

(11) **EP 3 577 406 B1**
(45) Date of publication and mention of the grant of the patent: **21.04.2021**
(21) Application number: 18704312.0
(22) Date of filing: 31.01.2018
(51) Int. Cl.: F28F 3/02, F28F 3/12, F28F 9/02, F28F 13/12, H01L 23/473

(54) **LIQUID COOLING SYSTEMS FOR HEAT GENERATING DEVICES**
FLÜSSIGKEITSKÜHLSYSTEME FÜR WÄRMEERZEUGENDE VORRICHTUNGEN
SYSTÈMES DE REFROIDISSEMENT PAR LIQUIDE POUR DISPOSITIFS DE GÉNÉRATION DE CHALEUR

(30) Priority: 03.02.2017 US 201762454321 P; 19.07.2017 US 201762534316 P
(43) Date of publication of application: 11.12.2019
(73) Proprietor: Asetek Danmark A/S, 9220 Aalborg East (DK)
(72) Inventor: LYKKE, Peter, 9000 Aalborg (DK)
(74) Representative: Chas. Hude A/S
(86) International application number: PCT/IB2018/050616
(87) International publication number: WO 2018/142310

(56) References cited:
- EP-A2- 1 808 892
- US-A1- 2011 108 247
- US-A1- 2012 014 066

## Description

### Technical Field

The present invention relates generally to liquid cooling systems for heat generating electronic devices. More specifically, the invention relates to improved cold plates for the liquid cooling systems.

### Background

During operation of a computer or other heat generating electronic device, the heat created inside the central processing unit (CPU) or other processing unit (e.g., graphics processing unit (GPU)) must be carried away fast and efficiently in order to keep the temperature within the design range specified by the manufacturer. Liquid cooling system have been used to cool heat generating electronic devices by circulating a cooling liquid through a cold plate that transfers the heat away from the heat generating electronic device to the cooling liquid and then to a heat exchanger where the heat may be discharged.

Liquid cooling systems have increased the cooling performance of cooling system compared to air-cooling systems. But, as CPUs, GPUs, and other heat generating electronic device continue to get faster they generate more heat requiring greater cooling capacity. Consequently, there is an ongoing need to continue increasing the cooling capacity of liquid cooling systems while at the same time minimizing their size, footprint, and cost. The present disclosure is directed to a liquid cooling system having an improved cold plate design.

US 2012/014066 A1 describes a heat exchanger wherein warping (bending) of an intervening member and a frame is suppressed when the intervening member and a wall portion of the frame member having different linear expansion coefficients are welded with each other. A method for manufacturing the heat exchanger, a semiconductor device wherein warping (bending) of an intervening member and a frame is suppressed, and a method for manufacturing the semiconductor device are also described. Specifically described is a heat exchanger wherein a fin member provided with a plurality of fins forming flow channels for a refrigerant is arranged within a frame which forms the outer casing. The frame has a first frame member (a first wall portion) to which insulating plates (intervening members) interposed between the frame and heat-generating bodies (semiconductor elements) are welded. The insulating plates (intervening members) have a linear expansion coefficient different from that of the frame. The first frame member is provided with elastically deformable projections (elastically deformable portions) along an arrangement surface of the outer surface on which the insulating plates (intervening members) are arranged.

US 2011/108247 A1 describes a semiconductor element cooling apparatus including: a first member whose first surface on which a semiconductor element is mounted, and whose second surface has fins that define coolant flow paths, that extend in a first direction, that stand from the second surface to a predetermined height, and that are spaced from each other by predetermined intervals; and a second member that defines the coolant flow paths that extend in the first direction. The fins have grooves which extend in a second direction that intersects the first direction and which have a depth that extends from the distal end side of the fins toward the second surface. The depth of the grooves is smaller than the height of the fins. A protrusion-forming member is disposed in the grooves, extends across adjacent fins, and forms protrusions in the coolant flow paths defined by the adjacent fins.

EP 1808892 A2 describes a heat sink or flowing coolant into inlet manifold channels extending into an inlet edge of a manifold where the flow is forced downward into parallel and spaced micro-channels extending across the manifold channels and re-directing the coolant up into and out of outlet manifold channels extending into an outlet edge of the manifold and interleaved with the inlet manifold channels, and by maintaining a base-width of the micro-channels in the range of forty microns to one hundred microns, maintaining a base-height of the micro-channels in the range of two hundred microns to four hundred microns, maintaining a manifold-height through of the manifold channels in the range of one thousand microns to three thousand microns, and maintaining a manifold-width of the manifold channels in the range of three hundred and fifty microns to one thousand microns.

### SUMMARY

In one aspect, the present disclosure is directed to a cold plate for a liquid cooling system, configured for cooling a heat generating electronic component. The cold plate may include a heat exchanging interface having a first surface and a second surface for contacting the heat generating electronic component opposite the first surface. The cold plate may also include a plurality of parallel fins extending from the first surface, the plurality of fins defining a plurality of channels. The cold plate may further include a plurality of slots formed in the plurality of fins transversely to the plurality of channels, wherein the plurality of slots includes two inner slots and two outer slots. The cold plate may also include a plurality of barrier walls that extend down into the plurality of slots, wherein the plurality of barrier walls includes two inner barrier walls and two outer barrier walls. The cold plate may further include a seal that has an inlet passage configured to direct a cooling liquid to the plurality of channels, wherein the seal defines a central channel configured to distribute the cooling liquid to the middle region of the plurality of fins. The central channel is positioned between the inner barrier walls about midway along a length of the plurality of fins. The cooling liquid supplied to the plurality of channels through the central channel splits and flows away from the middle of the plurality of fins.

Another aspect of the present disclosure is direct to a method of cooling a heat generating electronic component using a liquid cooling system. The method may include pumping cooling liquid to a cold plate. The cold plate may include a heat exchanging interface having a first surface and a second surface for contacting the heat generating electronic component opposite the first surface. The cold plate may also include a plurality of parallel fins extending from the first surface, the plurality of fins defining a plurality of channels. The cold plate may further include a plurality of slots formed in the plurality of fins transversely to the plurality of channels. The cold plate may also include a plurality of barrier walls that extend down into the plurality of slots and a seal that has an inlet passage configured to direct the cooling liquid to the plurality of channels. The method may also include directing the cooling liquid through the inlet passage of the seal, splitting the cooling liquid flow so it flows away from the middle of the plurality of channels down the channels enabling heat to transfer from the heat generating electronic device to the cooling liquid, wherein the barrier walls disrupt laminar flow and create turbulent flow of the cooling liquid as the cooling liquid flows underneath the barrier walls. The method may further include collecting the cooling liquid from outlet passages at each end of the plurality of channels and supplying the cooling liquid to a heat exchanger where the heat is transferred from the cooling liquid.

Another aspect of the present disclosure is directed to a liquid cooling system for a heat generating electronic component. The liquid cooling system may include a cold plate. The cold plate may include a heat exchanging interface having a first surface and a second surface for contacting the heat generating electronic component opposite the first surface. The cold plate may also include a plurality of parallel fins extending from the first surface, the plurality of fins defining a plurality of channels. The cold plate may further include a plurality of slots formed in the plurality of fins transversely to the plurality of channels. The cold plate may also include a plurality of barrier walls that extend down into the plurality of slots and a seal that has an inlet passage configured to direct the cooling liquid to the plurality of channels. Heat from the heat generating electronic device may be transferred to the cooling liquid as it flows through the plurality of channels. The system may also include a heat exchanger fluidly coupled to the cold plate, the heat exchanger transfers heat away from cooling liquid as the cooling liquid circulates through the heat exchanger. The system may further include a pump fluidly coupled to the cold plate and the heat exchanger, the pump circulates the cooling liquid through the cold plate and the heat exchanger.

Another aspect of the present disclosure is directed to a cold plate for a liquid cooling system, configured for cooling a heat generating electronic component. The cold plate may include a heat exchanging interface having a first surface and a second surface for contacting the heat generating electronic component opposite the first surface. The cold plate may also include a plurality of parallel fins extending from the first surface, the plurality of fins defining a plurality of channels. The cold plate may further include a plurality of slots formed in the plurality of fins transversely to the plurality of channels. The cold plate may also include a plurality of barrier walls that extend down into the plurality of slots. The cold plate may further include a seal that has an inlet passage configured to direct a cooling liquid to the plurality of channels. The plurality of slots may include two inner slots and the plurality of barrier walls may include two inner barrier walls.

Another aspect of the present disclosure is direct to a method of cooling a heat generating electronic component using a liquid cooling system. The method may include pumping cooling liquid to a cold plate. The cold plate may include a heat exchanging interface having a first surface and a second surface for contacting the heat generating electronic component opposite the first surface. The cold plate may also include a plurality of parallel fins extending from the first surface, the plurality of fins defining a plurality of channels. The cold plate may further include a plurality of slots formed in the plurality of fins transversely to the plurality of channels. The cold plate may also include a plurality of barrier walls that extend down into the plurality of slots and a seal that has an inlet passage configured to direct the cooling liquid to the plurality of channels. The method may also include directing the cooling liquid through the inlet passage of the seal, splitting the cooling liquid flow so it flows away from the middle of the plurality of channels down the channels enabling heat to transfer from the heat generating electronic device to the cooling liquid, wherein the barrier walls disrupt laminar flow and create turbulent flow of the cooling liquid as the cooling liquid flows underneath the barrier walls. The method may further include collecting the cooling liquid from outlet passages at each end of the plurality of channels and supplying the cooling liquid to a heat exchanger where the heat is transferred from the cooling liquid. The plurality of slots may include two inner slots and the plurality of barrier walls may include two inner barrier walls.

It may be one object of the invention to provide an improved cold plate design for liquid cooling systems, which is more efficient (e.g., greater heat transfer performance) than present cold plate design, which can be produced at a low cost enabling high production volumes. It may be another object to create a cold plate design, which is easy-to-use and implement, and which requires a low level of maintenance or no maintenance at all. It may be still another object of the present invention to create a cold plate design, which can be used with existing CPU types, and which can be used in existing computer systems.

### BRIEF DESCRIPTION OF THE FIGURES

FIG. 1 is a perspective view of an embodiment of a liquid cooling system that may include an exemplary cold plate embodiment, according to the present disclosure.
FIG. 2 is a perspective view of another embodiment of a liquid cooling system that may include an exemplary cold plate embodiment, according to the present disclosure.
FIG. 3 is a simplified schematic showing a cross-section view of the liquid cooling system along plate 3-3 of FIG. 2.
FIG. 4 is a perspective view of a cold plate, according to an exemplary embodiment.
FIG. 5 is another perspective view of the cold plate of FIG. 4.
FIG. 6 is a schematic cross-sectional view of a cold plate in a liquid cooling system, according to an exemplary embodiment.
FIG. 7 is a perspective view of the reference cold plate used for comparative testing.
FIG. 8 is a photograph of the reference cold plate used for comparative testing.
FIG. 9 is a photograph of the cold plate, according to an exemplary embodiment.
FIG. 10 is a photograph of the cold plate of FIG. 9 with the barrier walls inserted into the slots of the fins, according to an exemplary embodiment.
FIG. 11 is a seal of the cold plate, according to an exemplary embodiment.
FIG. 12 is a photograph of a cold plate, according to another exemplary embodiment.
FIG. 13 is a seal of the cold plate of FIG. 12, according to an exemplary embodiment.

### DETAILED DESCRIPTION

Reference will now be made in detail to embodiments of the present disclosure, examples of which are illustrated in the accompanying drawings. Where possible, the same reference numbers will be used throughout the drawings to refer to the same or like parts.

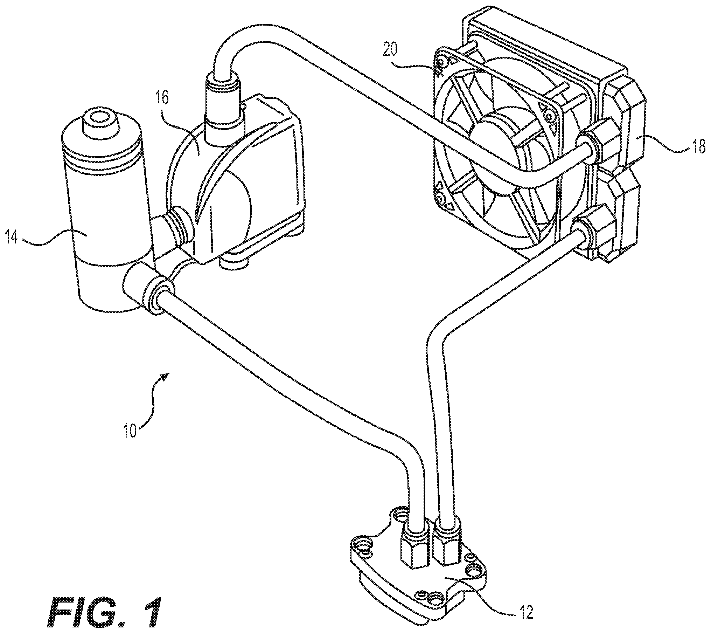

FIG. 1 shows one illustrative example of a liquid cooling system 10. Liquid cooling system 10 may include a cold plate 12, a liquid reservoir 14, a liquid pump 16, and a heat exchanger or radiator 18, which may be fluidly connected, as shown in FIG. 1. Cold plate 12 may be mountable to an electronic heat generating device (not shown), for example, a CPU, GPU, or other processing unit. Liquid reservoir 14 may function as a storage unit for excess cooling liquid not capable of being contained in the remaining components and may also be used to vent air from the system for filling the system with cooling liquid. Heat exchanger 18 may be configured to remove heat from the cooling liquid circulating through by blowing air through heat exchanger 18 via air fan 20. As shown in FIG. 1, the various components of liquid cooling system 10 may be connected with each other via tubes or conduits designed to circulate the cooling liquid.

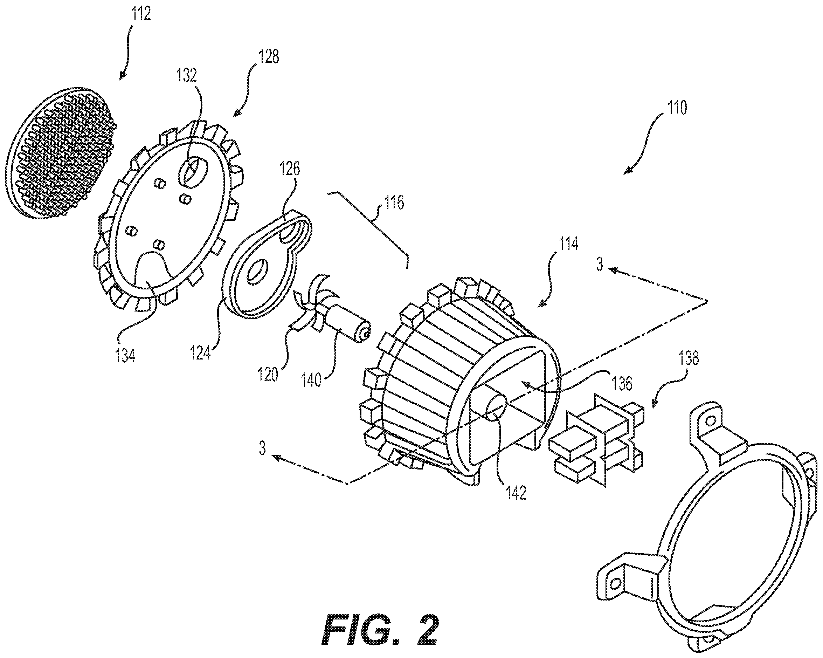

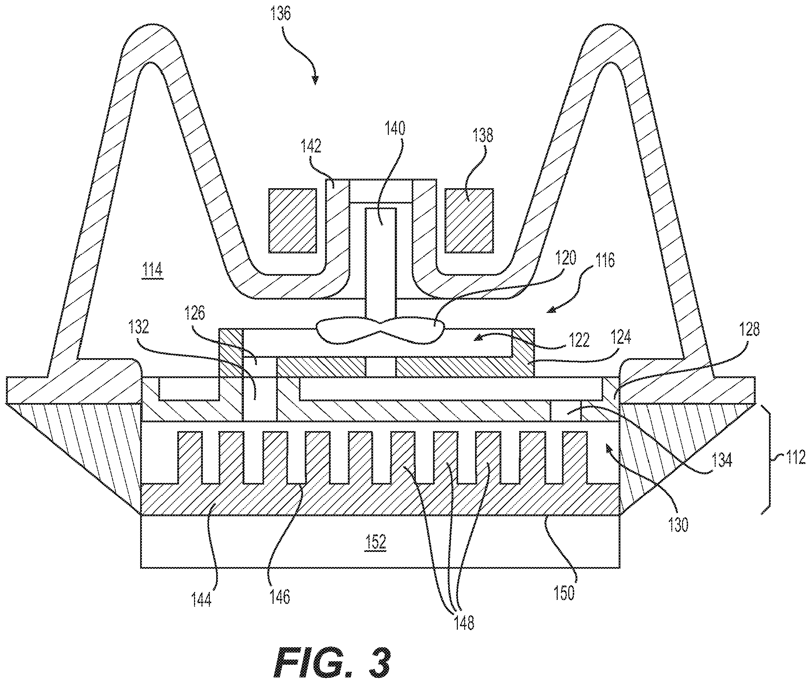

FIG. 2 and 3 show another illustrative example of a liquid cooling system 110. Liquid cooling system 110 may include a reservoir 114, as shown in FIGS. 2 and 3, which may be defined by a double-sided chassis housing configured to mount an electrical motor. In the embodiment shown, reservoir 114 has a conical, circular configuration and is provided with stiffening ribs extending axially along the housing. It is contemplated that other configurations of reservoir 114 may be utilized. For example, other shapes such as cylindrical, circular, or conical rectangular or cylindrical, rectangular or even oval or triangular shapes may be adopted, when designing and possibly injection molding or casting the reservoir.

Although not shown in FIGS. 2 or 3, the housing for reservoir 114 may be provided with an inlet and an outlet for circulating the liquid through a heat exchanger (not shown), which may be comparable to heat exchanger 18 (see FIG. 1). For some embodiments, the heat exchanger may be considered a component of liquid cooling system 110 while for other embodiments the heat exchanger may be considered a separate component. The inlet and the outlet may be provided along any suitable surface of the housing for reservoir 114. The heat exchanger may be positioned nearby or distant from liquid cooling system 110, depending on the set-up of the heat generating electronic device and associated computer system. In some embodiments, the heat exchanger may be placed in the immediate vicinity of reservoir 114, thereby potentially eliminating the need for any tubing between the heat exchanger and the inlet and the outlet, respectively. Such embodiment provides a very compact configuration for liquid cooling system 110.

As shown in FIGS. 2 and 3, liquid cooling system 110 may include a pump 116. Pump 116 may include an impeller 120 positioned within a pump chamber 122, which may be at least partially defined by an impeller cover 124. Impeller cover 124 may include an outlet 126 positioned tangentially to the circumference of impeller 120. Thus, pump 116 may function as a centrifugal pump. As shown in FIG. 3, pump chamber 46 may be open to reservoir 114 on the side opposite impeller cover 124 enabling direct flow of cooling liquid from reservoir 114 to pump chamber 122.

Liquid cooling system 110 may also include an intermediate member 128 positioned between pump chamber 122 and a cold plate 112. Intermediate member 128 and cold plate 112 may define a thermal exchange chamber 130, as shown in FIG. 3. Intermediate member 128 may be provided with an inlet passage 132 for directing cooling liquid discharged through outlet 126 from pump chamber 122 to thermal exchange chamber 130. Intermediate member 128 may be provided with one or more outlet passages 134 for directing the cooling liquid out of the thermal exchanger chamber 130. In some embodiments, the one or more outlet passages 134 may direct the cooling liquid back into reservoir 114 from where it may be circulated through the heat exchanger. In other embodiments, the one or more outlet passages 134 may direct the cooling liquid directly to the heat exchanger where it may be circulated back to reservoir 114 once cooled. In some embodiments, one outlet passage 134 may direct cooling liquid back to reservoir 114 while the other may direct cooling liquid to the heat exchanger. In some embodiments, intermediate member 128 and impeller cover 124 may be formed as one component.

The housing for reservoir 114 may have a recess 136 in the center on the upper side. Recess 136 may be configured for accommodating a stator 138 of an electrical motor for driving impeller 120 of pump 116. Impeller 120 may be attached to a shaft of a rotor 140 of the electrical motor. Recess 136 may include an orifice, four sidewalls, a bottom and a circular jacket 142 extending from the bottom of recess 136 outwards towards the orifice of recess 136. The interior (see FIG. 3) of circular jacket 142 may be configured to house rotor 140 of the electrical motor. Thereby, a liquid-proof division may be achieved between rotor 140, positioned inside the interior of circular jacket 142 (submerged in cooling liquid) and stator 138 positioned in the recess 40 surrounding the exterior of circular jacket 142. Thus, for such embodiments, stator 138 does not need to be separately sealed from the cooling liquid.

Cold plate 112 may include a heat exchanging interface 144 with a first surface 146 having a plurality of fins 148 extending from the first surface toward intermediate member 128 and a second surface 150, opposite first surface 146, configured to contact a heat generating electronic device 152. In some embodiments, cold plate 112 may be made from a copper plate and the plurality of fins may be formed by a skiving process. It is contemplated that other suitable metals may be used to form cold plate 112 including heat exchanging interface 144 and/or the plurality of fins.

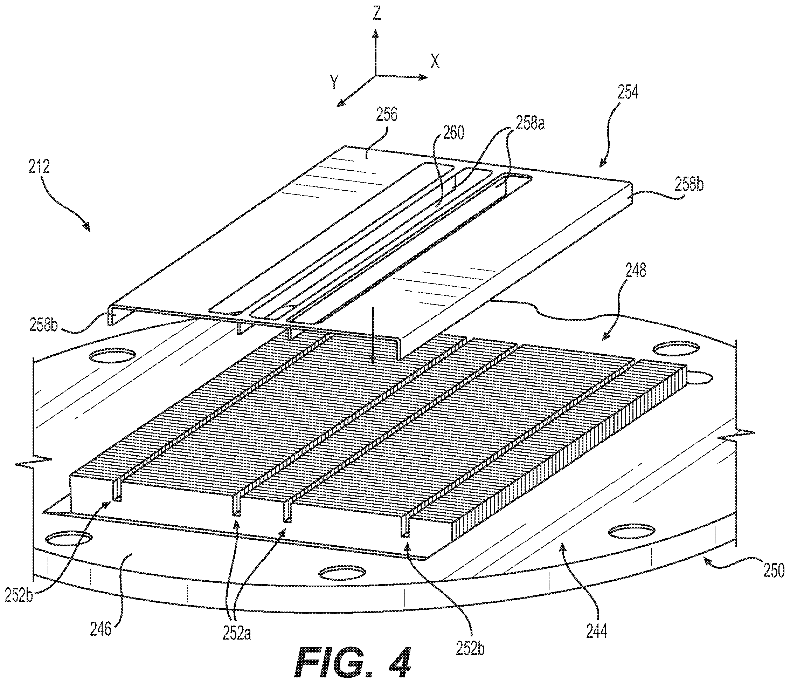

FIG. 4 shows a perspective view of an exemplary embodiment of a cold plate 212, which may be interchangeable with other cold plates of liquid cooling systems, including for example, cold plates 12, 112 of liquid cooling systems 10, 110. As shown in FIG. 4, cold plate 212 may include a heat exchanging interface 244 having a first surface 246 having a plurality of parallel fins 248 extending from first surface 246 and a second surface 250, opposite the first surface 246, configured to contact a heat generating electronic device (not shown). The plurality of parallel fins 248 may define a plurality of parallel channels between adjacent fins. The plurality of fins 248 may be formed by any suitable process, including for example, skiving.

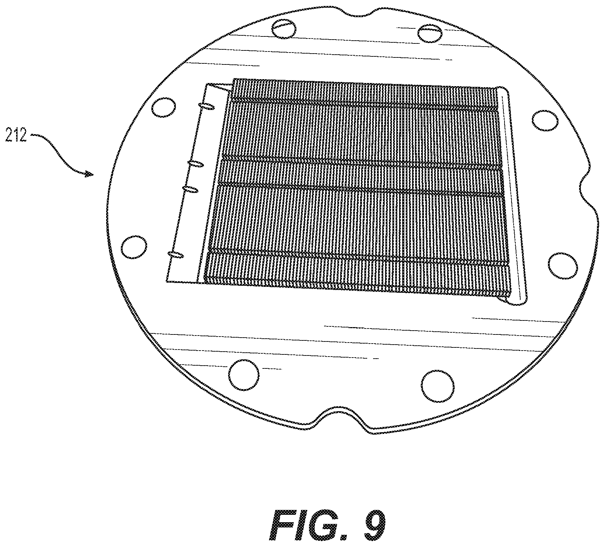

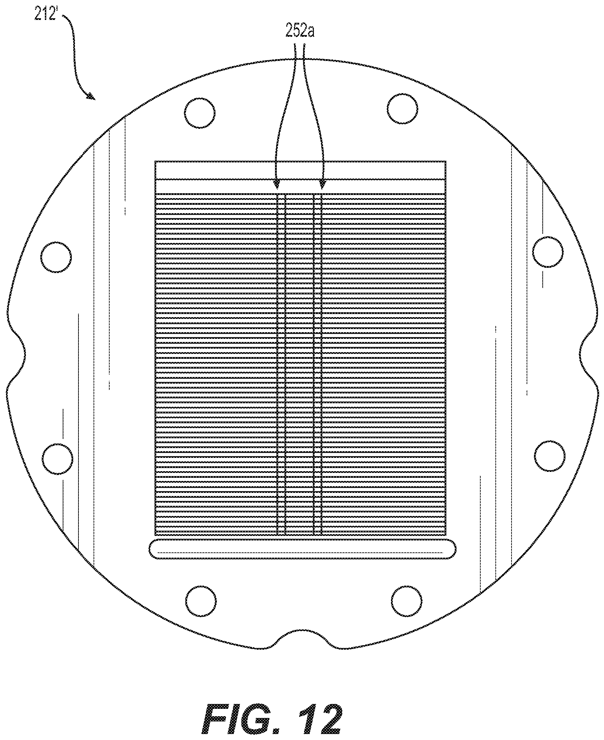

Cold plate 212 may also include a plurality of slots 252 positioned transversely to the plurality of fins 248. The number of slots 252 may vary, for example, as shown in FIG. 4, cold plate 212 may include a total of four slots 252, two inner slots 252a and two outer slots 252b. In another example, as shown in FIG. 12, another exemplary embodiment of a cold plate 212' includes two inner slots 252a and no outer slots. The slots 252 may have a depth that is less than a height of the plurality of fins 248. For example, in some embodiments, a depth of the slots may be about 10%, 20%, 30%, 40, 50%, 60%, 70%, 80%, or 90% a height of the plurality of fins. As shown in FIG. 4, the depth of the slots 252 may be the same for all the slots. In other embodiments, the depth of the slots 252 may be different. For example, the inner slots 252a may have a greater or lesser depth than the outer slots 252b. The width of slots 252 may also vary. FIG. 9 is a photograph of cold plate 212 showing the plurality of fins and slots.

As shown in FIG. 4, cold plate 212 may also include a plurality of barrier walls 258. The number of barrier walls 258 may correspond to the number of slots 252. For example, as shown in FIG. 4, cold plate 212 may have four barrier walls 258, two inner barrier walls 258a and two outer barrier walls 258b. Cold plate 212', as shown in FIG. 12 may have two barrier walls 258, for example, two inner barrier walls 258a and no outer barrier walls. A depth of the barrier walls 258 may correspond to the depth of the slots such that when the barrier walls 258 are positioned in the slots, the barrier walls 258 extend completely down into slots 252 to the bottom. A width of the barrier walls 258 may correspond to the width of the slots such that easy installation of the barrier walls 259 is possible without bending or damaging any of the fins 248.

In some embodiments, as shown in FIG. 4, the barrier walls may be formed as part of a plate 254 that is configured to be positioned on top of the plurality of fins 248. Plate 254 may be formed of a substantially planar sheet or plate-like element 256 and the plurality of barrier walls 258 may extend down perpendicular to the planar element toward the plurality of fins 248. Plate 254 may include one or more openings in planar element 256. For example, as shown in FIG. 4, plate 254 may include a central opening 260 positioned between inner barrier walls 258a. Central opening 260 may have an elongated rectangular shape that extends substantially a width of plate 254 along a Y-axis. In some embodiments, as shown in FIG. 4, on both sides of central opening 260 may be additional openings on the other sides of inner barrier walls 258a.

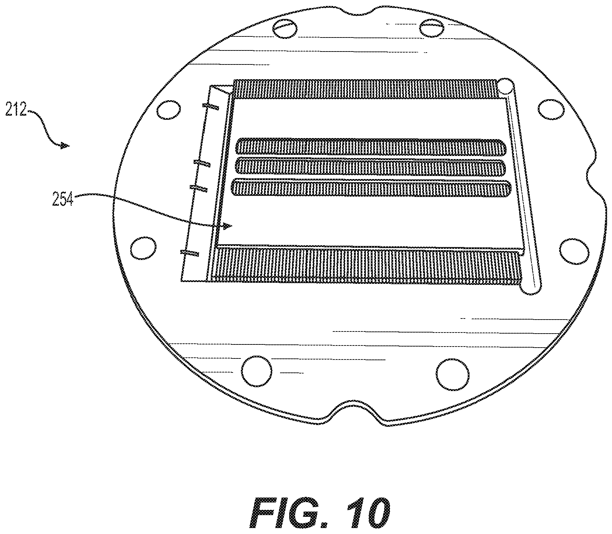

These additional openings may be similarly shaped and sized as central opening 260. FIG. 10 is a photograph of cold plate 212 with barrier walls 258 installed in slots 252.

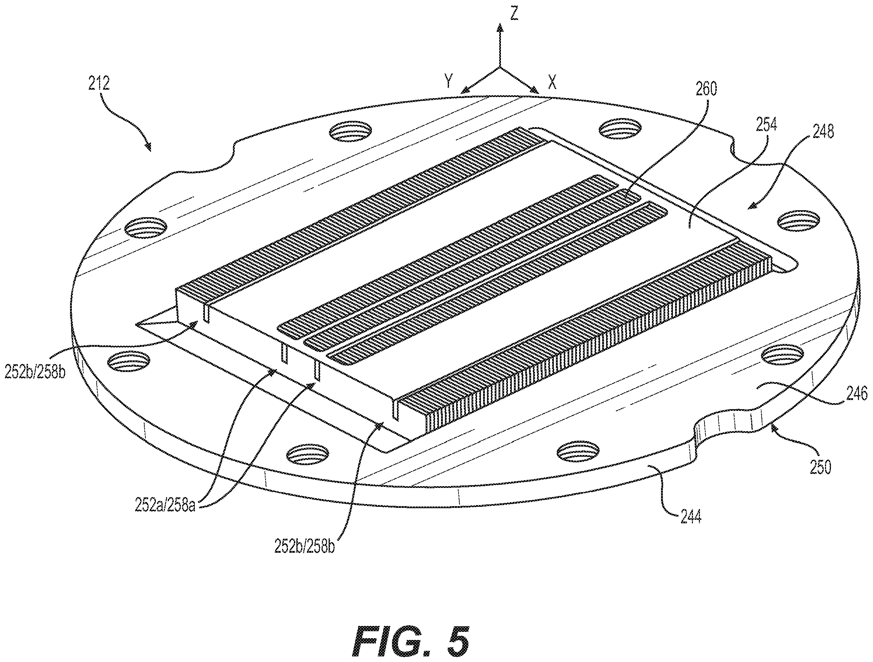

FIG. 5 shows cold plate 212 with plate 254 positioned on top of the plurality of fins 248 such that the plurality of barrier walls 258 are inserted into the plurality of slots 252. As shown in FIG. 5, the width of plate 254 along the Y-axis may be substantially equal to a width of the plurality of fins 248 along the Y-axis while a length of 254 plate along the X-axis may be less than a length of the plurality of fins 248 along the x-axis.

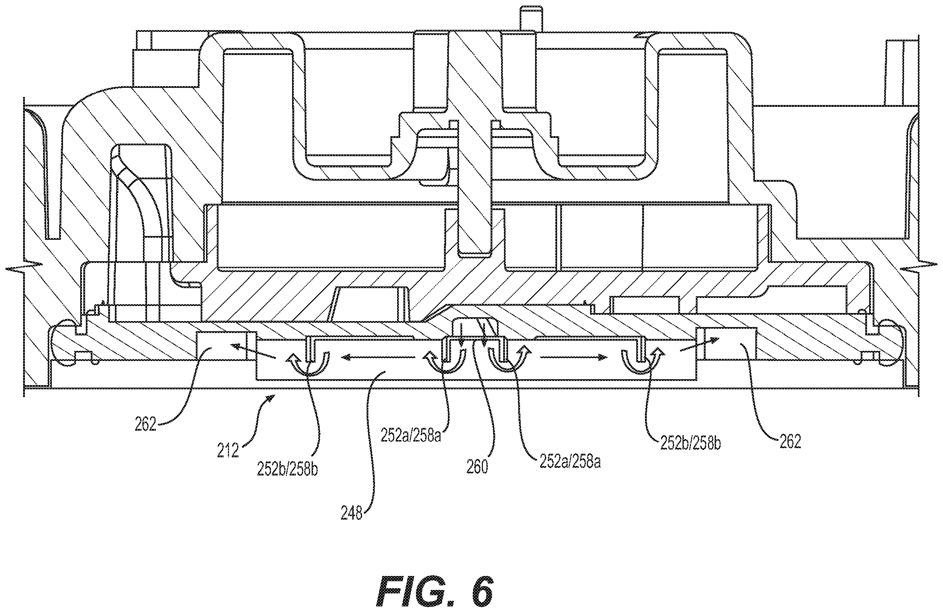

Cold plate 212 when installed in a liquid cooling system (e.g., 10 or 110) may be connected so that central opening 260 is fluidly connected to an inlet passage that delivers the cooling liquid. Thus, cooling liquid is able to get distributed across the full cross-sectional area of central opening 260 and directed to all of the plurality of fins 248. The cooling liquid once it enters the plurality of channels between the plurality of fins 248 will split and flow in both directions away from central opening 260. For example, FIG. 6 is a schematic cross-sectional view illustrating a representative flow path of cooling liquid through cold plate 212. As shown in FIG. 6, the cooling liquid may pass through central opening 260 into the plurality of fins 248 and then may split. As shown in FIG. 6, barrier walls 258 that extend down into slots 252 act as obstacles forcing the cooling liquid to flow around the barrier walls. By redirecting the flow around the barrier walls turbulence in introduced in the cooling fluid flow. Increasing turbulence within the cooling fluid flow can be beneficial because it breaks up laminar flow causing more turbulent flow of the cooling liquid. This is beneficial because as the cooling liquid flows through the channels it tends to become more laminar flow creating a border layer of flow to build up along the fins and this border layer acts as insulator reducing the rate of heat transfer between the fins and the cooling liquid. Thus, by introducing the barrier walls into the flow path of the cooling liquid, laminar flow is broken up and turbulence is introduced, which increases the heat transfer rate between the fins and the cooling liquid. It is to be understood that other terms, including for example, directors, diverters, or turbulence effectors may be used in place of barrier walls.

As shown in FIG. 6, once the flow of the cooling liquid is split, each flow path is diverted around an inner barrier wall 258a and then an outer barrier wall 258b, both of which can act as a turbulence effector by breaking up laminar flow of the cooling liquid. It is contemplated that the positioning of the slots 252 and barrier walls 258 may be adjusted along the flow path of the cooling liquid. For example, in other embodiments the inner barrier walls 258a may be positioned further from central opening 260 thus reducing the distance between inner barrier walls 258a and outer barrier walls 258b, and thus reducing the available distance for laminar flow to get established before being disrupted by outer barrier walls 258b. It is also contemplated that in other embodiments additional or fewer barrier walls may be added. For example, intermediate barrier walls may be added between the inner barrier walls and the outer barrier walls. In another example, as shown in FIG. 12, outer barrier walls may be removed and just two inner barrier walls 258a may be utilized to act as a turbulence effector by breaking up laminar flow of the cooling liquid.

As shown in FIG. 6, cooling liquid may exit from the plurality of fins 248 at each end where the cooling liquid may be collected and discharged through outlet passages 262.

FIG. 6 shows cold plate 212 incorporated into a liquid cooling system similar to liquid cooling system 110 where the pump and reservoir are positioned above the cold plate. It is to be understood that the operation, performance, and flow path characteristics for cold plate 212 described herein are also applicable to other embodiments of liquid cooling systems, including liquid cooling systems 10, 110.

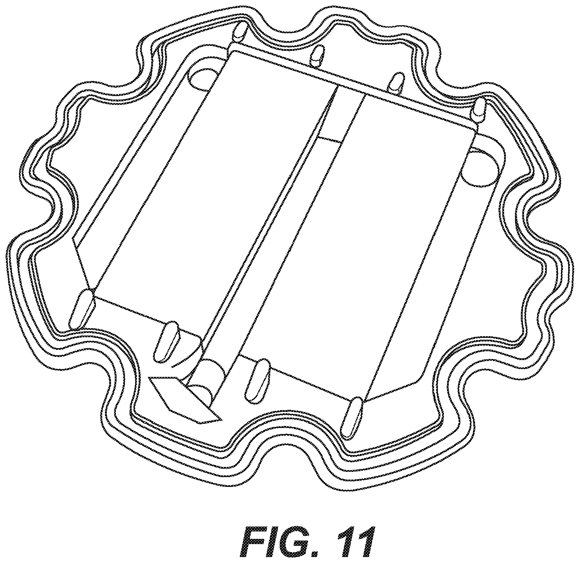

Barrier walls 258 and/or plate 254 may be manufactured by any suitable material capable of acting as a barrier to a cooling liquid, including for example, metals (e.g., copper, stainless steel, zinc, chromium), composites, or polymers (e.g., rubber). Although not shown in FIGS. 5 or 6, cold plate 212 may include a seal or gasket designed to be positioned on top of the plurality of fins 248 and for some embodiments on top of plate 254, designed to direct the cooling liquid to central opening 260, the additional openings, and/or outlet passages 262. For example, FIG. 11 shows an embodiment of a seal designed to be positioned on top of the plurality of fins 248. The seal may include an inlet passage and central channel designed to distribute the cooling liquid to the middle of the plurality of fins 248 and through central opening for embodiments, which include plate 254. As shown in FIG. 11, the seal may also include two outlet passages at opposite ends designed to discharge the cooling liquid from the plurality of fins 248.

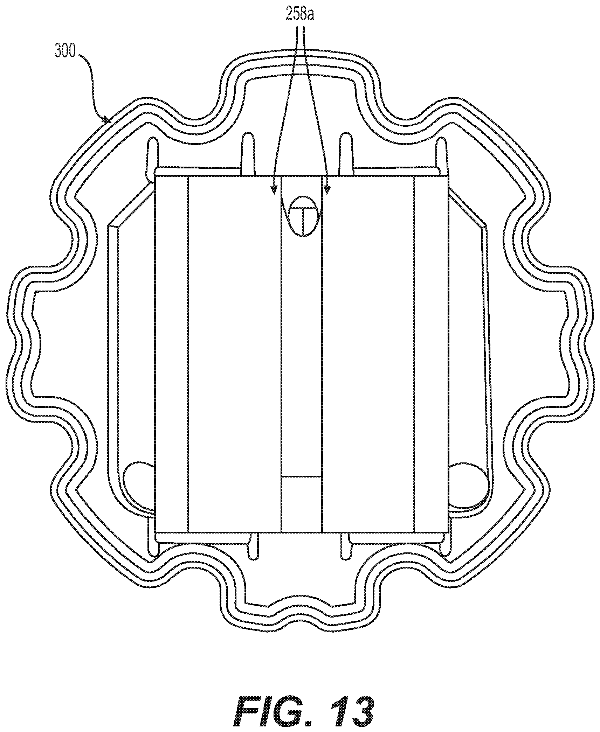

In some embodiments, the seal may be manufactured to include the barrier walls 258. For example, the seal may be manufactured from a polymer or other suitable rubber like material capable of liquid sealing, but rigid enough such that the barrier walls are able to maintain their structure. For example, seal 300 shown in FIG. 13 is formed with two inner barrier walls 258a corresponding in position to inner slots 252a of cold plate 212' shown in FIG. 12.

In some embodiments, the barrier walls 258 may be independent walls positioned in the slots that are held in places by the positioning of the seal on top of the plurality of fins 248. In some embodiments, the barrier walls 258 may be formed from a gasket or rough o-ring that is threaded down into the slots. It is to be understood that the barrier walls may be formed of any suitable material that is capable of diverting the cooling liquid.

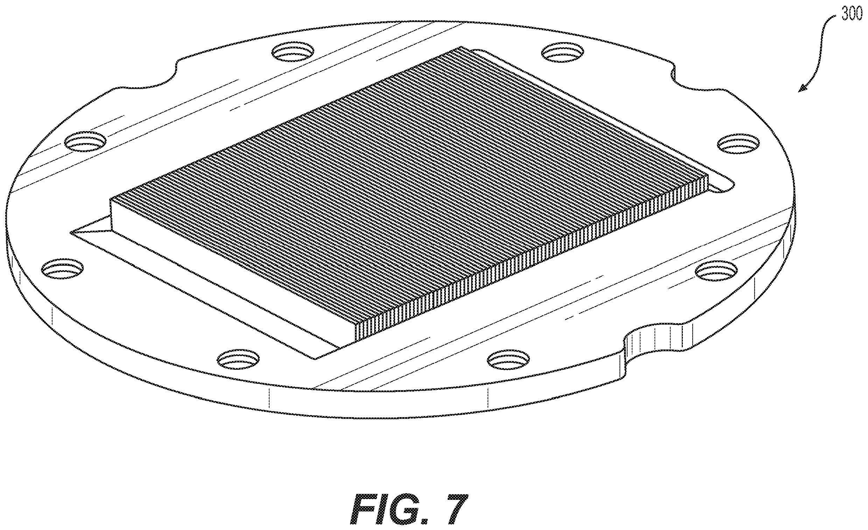

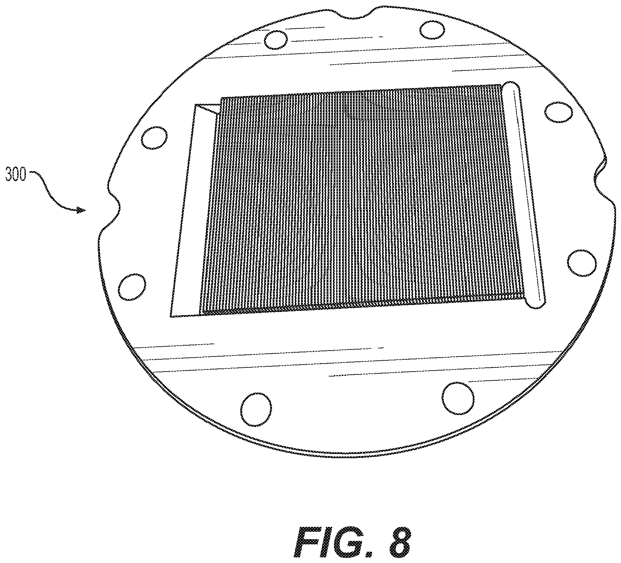

In order to quantity the heat transfer performance improvement provided by cold plate 212, comparative testing was done. FIG. 7 shows a prospective view of a reference cold plate 300 used for the testing and FIG. 8 shows is a photograph of the reference cold plate used for testing. As shown in FIGS. 7 and 8, unlike cold plate 212, the reference cold plate 300 included no slots nor did it have barrier walls designed to create turbulence breaking up the laminar flow.

Both cold plates 212 and 300 where run with split flow using the same gasket (see FIG. 11) on a test bench system where they were each hooked up to the same liquid cooling system, which had a pump for circulating the cooling liquid and a heat exchanger for discharging the heat. Each cold plate was attached to a heat generating device (CPU) operating at the same levels for both tests. The results show that the thermal resistance for the reference cold plate shown in FIGS. 7 and 8 was 0.031 °C/W while the thermal resistance for cold plate 212 as shown in FIG. 5 was 0.027 °C/W. Thus, cold plate 212 exhibited a thermal resistance 0.004 °C/W lower than the reference cold plate, which equates to about a 13% decrease in the cold plate thermal resistance. This decrease in the thermal resistance demonstrates how cold plate 212 is less resistant to heat transfer than the reference cold plate and therefore is capable of transferring heat more efficiently than the reference cold plate. During the testing the overall liquid cooling system performance was also measured and it was determined the thermal resistance for the overall system running with the reference cold plate 300 was 0.091 °C/W while the thermal resistance for the overall system running cold plate 212 was 0.088 °C/W. The thermal resistance of the heat exchanger was also measured and it was substantially the same at 0.06 °C/W for both tests. Thus, the improvement in overall system performance seen it attributable to cold plate 212.

Other embodiments will be apparent from consideration of the specification and practice of the embodiments disclosed herein. It is intended that the specification and examples be considered as example only, with the scope of protection beeing defined by the following claims.

## Claims

1. A cold plate (12) for a liquid cooling system (10), configured for cooling a heat generating electronic component, the cold plate (12) comprising:
a heat exchanging interface (144) having a first surface (146) and a second surface (150) for contacting the heat generating electronic component opposite the first surface (146);
a plurality of parallel fins (148) extending from the first surface (146), the plurality of fins (148) defining a plurality of channels;
a plurality of slots (252) formed in the plurality of fins (148) transversely to the plurality of channels, wherein the plurality of slots (252) include two inner slots (252a) and two outer slots (252b), and
a plurality of barrier walls (258) that extend down into the plurality of slots (252), wherein the plurality of barrier walls (258) include two inner barrier walls (258a) and two outer barrier walls (258b); and
a seal that has an inlet passage configured to direct a cooling liquid to the plurality of channels, wherein the seal defines a central channel configured to distribute the cooling liquid to the middle region of the plurality of fins (148), wherein the central channel is positioned between the inner barrier walls (258a) about midway along a length of the plurality of fins (148) and wherein the cooling liquid supplied to the plurality of channels through the central channel splits and flows away from the middle of the plurality of fins (148).

2. The cold plate of claim 1, wherein the inner barrier walls (258a) and outer barrier walls (258b) force the cooling liquid to flow around disrupting laminar flow and creating turbulent flow of the cooling liquid as it flows through the plurality of channels.

3. The cold plate of claim 1, further comprising a plate (256) configured to cover a portion of the plurality of fins (248), wherein the plurality of barrier walls (258) extend down from the plate (256) and the plate (256) includes a central opening (260) that corresponds with the central channel.

4. A method of cooling a heat generating electronic component using a liquid cooling system, the method comprising:
pumping cooling liquid to a cold plate (12), wherein the cold plate includes:
a heat exchanging interface having a first surface (146) and a second surface (150) for contacting the heat generating electronic component opposite the first surface;
a plurality of parallel fins (148) extending from the first surface (146), the plurality of fins (148) defining a plurality of channels;
a plurality of slots (252) formed in the plurality of fins (148) transversely to the plurality of channels;
a plurality of barrier walls (258) that extend down into the plurality of slots (252); and
a seal that has an inlet passage configured to direct the cooling liquid to the plurality of channels;
directing the cooling liquid through the inlet passage of the seal, splitting the cooling liquid flow so it flows away from the middle of the plurality of channels down the channels enabling heat to transfer from the heat generating electronic device to the cooling liquid, wherein the barrier walls (258) disrupt laminar flow and create turbulent flow of the cooling liquid as the cooling liquid flows underneath the barrier walls (258);
collecting the cooling liquid from outlet passages at each end of the plurality of channels and supplying the cooling liquid to a heat exchanger where the heat is transferred from the cooling liquid.

5. The method of claim 4, wherein the plurality of slots (252) include two inner slots (252a) and two outer slots (252b) and the plurality of barrier walls (258) include two inner barrier walls (258a) and two outer barrier walls (258b).

6. The method of claim 5, wherein the seal defines a central channel configured to distribute the cooling liquid to the middle region of the plurality of fins (148), wherein the central channel is positioned between the inner barrier walls (258a) about midway along a length of the plurality of fins (148).

7. The cold plate of claim 1, wherein said cold plate (12) is fluidly coupled to a pump, said pump (16) circulating the cooling liquid through the cold plate (12).

8. The cold plate of claim 7, wherein the seal defines a central channel configured to distribute the cooling liquid to the middle region of the plurality of fins (148), wherein the central channel is positioned between the inner barrier walls (258a) about midway along a length of the plurality of fins (148).

9. The cold plate of claim 8, wherein the cooling liquid supplied to the plurality of channels through the central channel splits and flows away from the middle of the plurality of fins (148).

10. The cold plate of claim 8, wherein the inner barrier walls (258a) force the cooling liquid to flow around disrupting laminar flow and creating turbulent flow of the cooling liquid as it flows through the plurality of channels.

11. The cold plate of claim 7, wherein the plurality of barrier walls (258) are part of the seal and extend down from the seal toward the first surface (146) of the heat exchanging interface.

12. The method of claim 4, wherein the plurality of slots (252) include two inner slots (252a) and the plurality of barrier walls (258) include two inner barrier walls (258a).

13. The method of claim 12, wherein the seal defines a central channel configured to distribute the cooling liquid to the middle region of the plurality of fins (148), wherein the central channel is positioned between the inner barrier walls (258a) about midway along a length of the plurality of fins (148).

14. The method of claim 12, wherein the plurality of barrier walls (258) are part of the seal and extend down from the seal toward the first surface (146) of the heat exchanging interface.

## Patentansprüche

1. Kühlplatte (12) für ein Flüssigkeitskühlsystem (10), die zum Kühlen einer wärmeerzeugenden elektronischen Komponente konfiguriert ist, wobei die Kühlplatte (12) umfasst:
eine Wärmetauscherschnittstelle (144) mit einer ersten Oberfläche (146) und einer zweiten Oberfläche (150) zum Kontaktieren der wärmeerzeugenden elektronischen Komponente gegenüber der ersten Oberfläche (146);
eine Vielzahl von parallelen Rippen (148), die sich von der ersten Oberfläche (146) erstrecken, wobei die Vielzahl von Rippen (148) eine Vielzahl von Kanälen definiert;
eine Vielzahl von Schlitzen (252), die in der Vielzahl von Rippen (148) quer zu der Vielzahl von Kanälen ausgebildet sind, wobei die Vielzahl von Schlitzen (252) zwei innere Schlitze (252a) und zwei äußere Schlitze (252b) umfasst, und
eine Vielzahl von Sperrwänden (258), die sich nach unten in die Vielzahl von Schlitzen (252) erstrecken, wobei die Vielzahl von Sperrwänden (258) zwei innere Sperrwände (258a) und zwei äußere Sperrwände (258b) umfassen; und
eine Dichtung, die einen Einlassdurchgang aufweist, der so konfiguriert ist, dass er eine Kühlflüssigkeit zu der Vielzahl von Kanälen leitet, wobei die Dichtung einen zentralen Kanal definiert, der so konfiguriert ist, dass er die Kühlflüssigkeit zum mittleren Bereich der Vielzahl von Rippen (148) verteilt, wobei der zentrale Kanal zwischen den inneren Sperrwänden (258a) etwa in der Mitte entlang einer Länge der Vielzahl von Rippen (148) positioniert ist und wobei sich die Kühlflüssigkeit, die der Vielzahl von Kanälen durch den zentralen Kanal zugeführt wird, aufteilt und von der Mitte der Vielzahl von Rippen (148) wegfließt.

2. Kühlplatte nach Anspruch 1, wobei die inneren Sperrwände (258a) und die äußeren Sperrwände (258b) die Kühlflüssigkeit zum Umströmen zwingen, wodurch die laminare Strömung unterbrochen und eine turbulente Strömung der Kühlflüssigkeit erzeugt wird, während sie durch die Vielzahl von Kanälen fließt.

3. Kühlplatte nach Anspruch 1, die ferner eine Platte (256) umfasst, die so konfiguriert ist, dass sie einen Teil der Vielzahl von Rippen (248) abdeckt, wobei sich die Vielzahl von Sperrwänden (258) von der Platte (256) nach unten erstreckt und die Platte (256) eine zentrale Öffnung (260) enthält, die mit dem zentralen Kanal übereinstimmt.

4. Verfahren zum Kühlen einer wärmeerzeugenden elektronischen Komponente unter Verwendung eines Flüssigkeitskühlsystems, wobei das Verfahren umfasst:
Pumpen von Kühlflüssigkeit zu einer Kühlplatte (12), wobei die Kühlplatte umfasst:
eine Wärmetauscherschnittstelle mit einer ersten Oberfläche (146) und einer zweiten Oberfläche (150) zum Kontaktieren der wärmeerzeugenden elektronischen Komponente gegenüber der ersten Oberfläche;
eine Vielzahl von parallelen Rippen (148), die sich von der ersten Oberfläche (146) erstrecken, wobei die Vielzahl von Rippen (148) eine Vielzahl von Kanälen definiert;
eine Vielzahl von Schlitzen (252), die in der Vielzahl von Rippen (148) quer zu der Vielzahl von Kanälen ausgebildet sind;
eine Vielzahl von Sperrwänden (258), die sich nach unten in die Vielzahl von Schlitzen (252) erstrecken;
und
eine Dichtung, die einen Einlassdurchgang aufweist, der so konfiguriert ist, dass er die Kühlflüssigkeit zu der Vielzahl von Kanälen leitet;
Leiten der Kühlflüssigkeit durch den Einlassdurchgang der Dichtung, Aufteilen der Kühlflüssigkeitsströmung, so dass sie von der Mitte der Vielzahl von Kanälen weg die Kanäle nach unten fließt, was die Übertragung von Wärme von der wärmeerzeugenden elektronischen Vorrichtung auf die Kühlflüssigkeit ermöglicht, wobei die Sperrwände (258) die laminare Strömung unterbrechen und eine turbulente Strömung der Kühlflüssigkeit erzeugen, wenn die Kühlflüssigkeit unter den Sperrwänden (258) fließt;
Sammeln der Kühlflüssigkeit aus Auslassdurchgängen an jedem Ende der Vielzahl von Kanälen und Zuführen der Kühlflüssigkeit zu einem Wärmetauscher, wo die Wärme von der Kühlflüssigkeit übertragen wird.

5. Verfahren nach Anspruch 4, wobei die Vielzahl von Schlitzen (252) zwei innere Schlitze (252a) und zwei äußere Schlitze (252b) umfasst und die Vielzahl von Sperrwänden (258) zwei innere Sperrwände (258a) und zwei äußere Sperrwände (258b) umfasst.

6. Verfahren nach Anspruch 5, wobei die Dichtung einen zentralen Kanal definiert, der so konfiguriert ist, dass er die Kühlflüssigkeit auf den mittleren Bereich der Vielzahl von Rippen (148) verteilt, wobei der zentrale Kanal zwischen den inneren Sperrwänden (258a) etwa in der Mitte entlang einer Länge der Vielzahl von Rippen (148) positioniert ist.

7. Kühlplatte nach Anspruch 1, wobei die Kühlplatte (12) strömungstechnisch mit einer Pumpe verbunden ist, wobei die Pumpe (16) die Kühlflüssigkeit durch die Kühlplatte (12) zirkulieren lässt.

8. Die Kühlplatte nach Anspruch 7, wobei die Dichtung einen zentralen Kanal definiert, der so konfiguriert ist, dass er die Kühlflüssigkeit auf den mittleren Bereich der Vielzahl von Rippen (148) verteilt, wobei der zentrale Kanal zwischen den inneren Sperrwänden (258a) etwa in der Mitte entlang einer Länge der Vielzahl von Rippen (148) positioniert ist.

9. Kühlplatte nach Anspruch 8, wobei sich die Kühlflüssigkeit, die der Vielzahl von Kanälen durch den zentralen Kanal zugeführt wird, aufteilt und von der Mitte der Vielzahl von Rippen (148) wegfließt.

10. Kühlplatte nach Anspruch 8, wobei die inneren Sperrwände (258a) die Kühlflüssigkeit zum Umströmen zwingen, wodurch die laminare Strömung unterbrochen und eine turbulente Strömung der Kühlflüssigkeit erzeugt wird, während sie durch die Vielzahl von Kanälen fließt.

11. Kühlplatte nach Anspruch 7, wobei die Vielzahl von Sperrwänden (258) Teil der Dichtung sind und sich von der Dichtung nach unten in Richtung der ersten Oberfläche (146) der Wärmetauscherschnittstelle erstrecken.

12. Verfahren nach Anspruch 4, wobei die Vielzahl von Schlitzen (252) zwei innere Schlitze (252a) und die Vielzahl von Sperrwänden (258) zwei innere Sperrwände (258a) umfassen.

13. Verfahren nach Anspruch 12, wobei die Dichtung einen zentralen Kanal definiert, der so konfiguriert ist, dass er die Kühlflüssigkeit auf den mittleren Bereich der Vielzahl von Rippen (148) verteilt, wobei der zentrale Kanal zwischen den inneren Sperrwänden (258a) etwa in der Mitte entlang einer Länge der Vielzahl von Rippen (148) positioniert ist.

14. Das Verfahren nach Anspruch 12, wobei die Vielzahl von Sperrwänden (258) Teil der Dichtung sind und sich von der Dichtung nach unten in Richtung der ersten Oberfläche (146) der Wärmetauscherschnittstelle erstrecken.

## Revendications

1. Plaque froide (12) pour un système de refroidissement par liquide (10), configurée pour refroidir un composant électronique produisant de la chaleur, la plaque froide (12) comprenant:
une interface d'échange de chaleur (144) ayant une première surface (146) et une deuxième surface (150) pour mettre en contact le composant électronique produisant de la chaleur qui est disposé à l'opposé de la première surface (146);
une pluralité d'ailettes parallèles (148) s'étendant depuis la première surface (146), la pluralité d'ailettes (148) définissant une pluralité de canaux;
une pluralité de fentes (252) formées dans la pluralité d'ailettes (148) transversalement à la pluralité de canaux, la pluralité de fentes (252) comprenant deux fentes intérieures (252a) et deux fentes extérieures (252b), et
une pluralité de parois de barrière (258) s'étendant vers le bas dans la pluralité de fentes (252), la pluralité de parois de barrière (258) comprenant deux parois de barrière intérieures (258a) et deux parois de barrière extérieures (258b); et
un joint ayant un passage d'entrée configuré pour diriger un liquide de refroidissement vers la pluralité de canaux, le joint définissant un canal central configuré pour distribuer le liquide de refroidissement à la zone centrale de la pluralité d'ailettes (148), le canal central étant positionné entre les parois de barrière intérieures (258a) à peu près à mi-chemin sur une longueur de la pluralité d'ailettes (148) et le liquide de refroidissement fourni à la pluralité de canaux à travers le canal central se séparant et s'écoulant du milieu de la pluralité d'ailettes (148).

2. Plaque froide selon la revendication 1, dans laquelle les parois de barrière intérieures (258a) et les parois de barrière extérieures (258b) forcent le liquide de refroidissement à s'écouler autour de l'écoulement laminaire perturbant et créer un écoulement turbulent du liquide de refroidissement lorsqu'il s'écoule à travers la pluralité de canaux.

3. Plaque froide selon la revendication 1, comprenant en outre une plaque (256) configurée pour couvrir une partie de la pluralité d'ailettes (248), dans laquelle la pluralité de parois de barrière (258) s'étendent vers le bas depuis la plaque (256), et la plaque (256) comprend une ouverture centrale (260) qui correspond au canal central.

4. Procédé de refroidissement d'un composant électronique produisant de la chaleur à l'aide d'un système de refroidissement par liquide, le procédé comprenant:
pompage du liquide de refroidissement vers une plaque froide (12), la plaque froide comprenant:
une interface d'échange de chaleur ayant une première surface (146) et une deuxième surface (150) pour entrer en contact avec le composant électronique produisant de la chaleur disposé à l'opposé de la première surface;
une pluralité d'ailettes parallèles (148) s'étendant depuis la première surface (146), la pluralité d'ailettes (148) définissant une pluralité de canaux;
une pluralité de fentes (252) formées dans la pluralité d'ailettes (148) transversalement à la pluralité de canaux;
une pluralité de parois de barrière (258) s'étendant vers le bas dans la pluralité de fentes (252) ; et
un joint ayant un passage d'entrée configuré pour diriger le liquide de refroidissement vers la pluralité de canaux;
diriger le liquide de refroidissement à travers le passage d'entrée du joint, diviser le flux de liquide de refroidissement de sorte qu'il s'écoule du milieu de la pluralité de canaux le long des canaux permettant le transfert de chaleur du dispositif électronique de production de chaleur au liquide de refroidissement, les parois de barrière (258) perturbant l'écoulement laminaire et créant un écoulement turbulent du liquide de refroidissement lorsque le liquide de refroidissement s'écoule sous les parois de barrière (258);
collecter le liquide de refroidissement des passages de sortie à chaque extrémité de la pluralité de canaux et fournir le liquide de refroidissement à un échangeur de chaleur où la chaleur est transférée du liquide de refroidissement.

5. Procédé selon la revendication 4, dans lequel la pluralité de fentes (252) comprennent deux fentes intérieures (252a) et deux fentes extérieures (252b) et la pluralité des parois de barrière (258) comprennent deux parois de barrière intérieures (258a) et deux parois de barrière extérieures (258b).

6. Procédé selon la revendication 5, dans lequel le joint définit un canal central configuré pour distribuer le liquide de refroidissement à la zone centrale de la pluralité d'ailettes (148), dans lequel le canal central est positionné entre les parois de barrière intérieures (258a) à peu près à mi-chemin sur une longueur de la pluralité d'ailettes (148).

7. Plaque froide selon la revendication 1, dans laquelle ladite plaque froide (12) est couplée fluidiquement à une pompe, ladite pompe (16) fait circuler le liquide de refroidissement à travers la plaque froide (12).

8. Plaque froide selon la revendication 7, dans laquelle le joint définit un canal central configuré pour distribuer le liquide de refroidissement à la zone centrale de la pluralité d'ailettes (148), dans laquelle le canal central est positionné entre les parois de barrière intérieures (258a) à peu près à mi-chemin le long d'une longueur de la pluralité d'ailettes (148).

9. Plaque froide selon la revendication 8, dans laquelle le liquide de refroidissement fourni à la pluralité de canaux à travers le canal central se sépare et s'écoule du milieu de la pluralité d'ailettes (148).

10. Plaque froide selon la revendication 8, dans laquelle les parois de barrière internes (258a) forcent le liquide de refroidissement à s'écouler autour d'un écoulement laminaire perturbant et créer un écoulement turbulent du liquide de refroidissement lorsqu'il s'écoule à travers la pluralité de canaux.

11. Plaque froide selon la revendication 7, dans laquelle la pluralité de parois de barrière (258) font partie du joint et s'étendent vers le bas depuis le joint vers la première surface (146) de l'interface d'échange de chaleur.

12. Procédé selon la revendication 4, dans lequel la pluralité des fentes (252) comprennent deux fentes intérieures (252a) et la pluralité de parois de barrière (258) comprennent deux parois de barrière intérieures (258a).

13. Procédé selon la revendication 12, dans lequel le joint définit un canal central configuré pour distribuer le liquide de refroidissement à la zone centrale de la pluralité d'ailettes (148), dans lequel le canal central est positionné entre les parois de barrière intérieures (258a) à peu près à mi-chemin le long d'une longueur de la pluralité d'ailettes (148).

14. Procédé selon la revendication 12, dans lequel la pluralité de parois de barrière (258) font partie du joint et s'étendent vers le bas depuis le joint vers la première surface (146) de l'interface d'échange de chaleur.
